Europäisches Patentamt

European Patent Office

Office européen des brevets

(11) Veröffentlichungsnummer: **0 026 933**
A2

(12) # EUROPÄISCHE PATENTANMELDUNG

(21) Anmeldenummer: 80106016.1

(22) Anmeldetag: 03.10.80

(51) Int. Cl.³: **H 01 G 4/40,** H 01 G 4/18, H 01 C 7/06, H 01 L 27/01

(30) Priorität: 04.10.79 DE 2940354

(43) Veröffentlichungstag der Anmeldung: 15.04.81 Patentblatt 81/15

(84) Benannte Vertragsstaaten: **FR GB IT SE**

(71) Anmelder: **SIEMENS AKTIENGESELLSCHAFT Berlin und München, Postfach 22 02 61, D-8000 München 22 (DE)**

(72) Erfinder: **Kausche, Helmold, Dipl.-Phys., Tessinerstrasse 146, D-8000 München 71 (DE)**
Erfinder: **Pachonik, Horst, Dipl.-Phys., Lindenring 135, D-8021 Taufkirchen (DE)**

(54) **RC-Netzwerk.**

(57) In einem RC-Netzwerk mit zumindest einer auf eine Kunststoffolie aufgebrachten Widerstandsschicht und einer Kapazität wird der Temperaturkoeffizient des Widerstandes durch den Temperaturkoeffizienten der Kapazität kompensiert, indem als Dielektrikum der Kapazität eine Glimmpolymerisatschicht verwendet wird und indem der Temperaturkoeffizient der Kapazität durch die Zusammensetzung des Dielektrikums eingestellt wird.

EP 0 026 933 A2

SIEMENS AKTIENGESELLSCHAFT       Unser Zeichen
Berlin und München              VPA 79 P 1 1 7 3 EUR

### RC-Netzwerk

Die vorliegende Erfindung betrifft ein RC-Netzwerk, welches zumindest einen auf eine Kunststoffolie aufgebrachten Widerstand enthält, wobei zumindest ein Metallbelag der Kapazität regenerierfähig dünn ist und wobei eine Glimmploymerisatschicht als Kondensatordielektrikum dient.

Ein derartiges RC-Netzwerk wurde an anderer Stelle bereits vrgeschlagen.

Insbesondere für Filterschaltungen muß der Temperaturkoeffizient des Widerstandes mit dem der Kapazität kompensiert werden, damit die ausgefilterten Frequenzen weitgehend temperaturunabhängig sind. Hierzu wurden bereits verschiedene keramische Werkstoffkombinationen angegeben, beispielsweise für den Widerstand $Ta_2N$, $TaON$, $AlTa$, $NiCr$ und für das Dielektrikum der Kapazität $\beta$-$Ta$, $\alpha$-$Ta$, $AlTa$-Oxid, $SiO_2$.

Die Aufgabe, die der vorliegenden Erfindung zugrundeliegt,

0026933

79 P 1 1 7 3 EUR

besteht bei einem RC-Netzwerk der eingangs beschriebenen Art darin, daß eine vollständige Kompensation der Temperaturkoeffizeinten des Widerstandes und der Kapazität für eine Serienfertigung ermöglicht wird. Insbesondere soll die Herstellung der Netzwerke im Bandverfahren ermöglicht werden, d.h. daß auf einem Band kontinuierlich Netzwerke hergestellt und erst nach ihrer Fertigung vom Band abgetrennt werden.

Diese Aufgabe wird gemäß der Erfindung dadurch gelöst, daß der Temperaturkoeffizient des Widerstandes durch den Temperaturkoeffizienten der Kapazität kompensiert ist und daß der Temperaturkoeffizeint der Kapazität durch die Zusammensetzung der Glimmpolymerisatschicht eingestellt ist.

Der Erfindung liegt die Erkenntnis zugrunde, daß sich der Temperaturkoeffizeint der Kapazität durch eine entsprechende Zusammensetzung der Glimmpolymerisatschicht mit guter Reproduzierbarkeit einstellen läßt. Zur Kompensation eines positiven Temperaturkoeffizeinten (TK) einer Widerstandsschicht durch einen negativen Temperaturkoeffizienten einer Kapazität wird vorteilhaft eine Glimmpolymerisatschicht als Kondensatordielektrikum verwendet, welche aus Polymerisat von Perfluordimethylcyclohexan und Cyclohexan zusammengesetzt ist und einen Temperaturkoeffizienten zwischen 0 und -200ppm/K aufweist. In vorteilhafter Ausgestaltung der Erfindung werden Widerstandsschichten aus Nickelchrom mit einem Temperaturkoeffizienten von +100ppm/K und eine Glimmpolymerisatschicht aus einem Mischpolymerisat als Dielektrikum eingesetzt, wobei das Mischpolymerisat etwa 10% Polymerisatanteile von Cyclohexan enthält. Hierdurch kann der Temperaturkoeffizient der genannten Widerstandsschicht auf 0 kompensiert werden.

Die Kapazität kann unmittelbar auf die Kunststoffolie des RC-Netzwerkes aufgebracht sein. Sie kann aber auch in Form eines gesonderten Kondensators hergestellt und auf das Widerstandsnetzwerk nachträglich aufgebracht, also aufhybridiert sein. In beiden Fällen läßt sich das Netzwerk im Bandverfahren herstellen.

Ein vorteilhaftes Verfahren zur Herstellung des vorgeschlagenen RC-Netzwerkes hat die Merkmale, daß die Polymerisation in einem Gasgemisch der entsprechenden Zusammensetzung erfolgt.

Vorteilhaft kann das Dielektrikum auch durch abwechselndes Aufpolymerisieren der beiden Stoffe im entsprechenden Verhältnis der Schichtdicken ($d_1 \ldots d_n$) erfolgen. Hierbei kann der Temperaturkoeffizient der Kapazität TKc gemäß der Formel

$$TK_c = \frac{d_1 TK_{c1} + d_2 TK_{c2} + \ldots d_n TK_{cn}}{d_1 + d_2 + \ldots d_n}$$

berechnet und besonders exakt eingestellt werden. Hierbei bedeutet $TK_{cn}$ den Temperaturkoeffizienten eines Kondensators mit dem Dielektrikum n und $d_n$ die Dicke des Dielektrikums n.

Das reine Perfluordymethylcyclohexan ergibt Kondensatoren mit einem Temperaturkoeffizienten der Kapazität von -210ppm/K im Temperaturbereich von 0° bis 100°C. Das reine Cyclohexan ergibt Kondensatoren mit einem Temperaturkoeffizienten der Kapazität zwischen 0° und 100°C von annähernd 300ppm/°C, wobei sich der Temperaturkoeffizient im angegebenen Temperaturbereich etwas ändert. Wird der Temperaturkoeffizient eines Mischpolymerisates in den angegebenen Grenzen von 0ppm/K bis -200ppm/K variiert, so entsteht ein Dielektrikum mit hoher Konstanz des Temperaturkoeffizeinten über den angegebenen Temperaturbereich.

Selbst bis zu einem Temperaturkoeffizienten von +200ppm/K ist der Temperaturkoeffizient des Mischpolymerisates noch von 0°C bis 70°C konstant, so daß auch ein derartiges Dielektrikum zur Kompensation des Temperaturkoeffizienten eines RC-Netzwerkes geeignet ist.

In einem Bereich von ±200ppm/K läßt sich bei der Herstellung durch die Zusammensetzung der Glimmpolymerisatschicht der Temperaturkoeffizient eines RC-Netzwerkes einstellen, beispielsweise wenn eine temperaturabhängige Filterkennlinie gewünscht wird, ohne daß eine unzulässige Temperaturabhängigkeit des Temperaturkoeffizienten auftritt.

5 Patentnasprüche

### Patentansprüche

1. RC-Netzwerk, welches zumindest einen auf eine Kunststoffolie aufgebrachten Widerstand und eine Kapazität enthält, wobei zumindest ein Metallbelag der Kapazität regenerierfähig dünn ist und wobei eine Glimmpolymerisat-schicht als Kondensatordielektrikum dient, d a d u r c h g e k e n n z e i c h n e t, daß der Temperaturkoeffi-zient des Widerstandes durch den Temperaturkoeffizienten der Kapazität kompensiert ist und daß der Temperaturkoeffizient der Kapazität durch die Zusammensetzung der Glimmpolymerisatschicht eingestellt ist.

2. RC-Netzwerk nach Anspruch 1, d a d u r c h g e - k e n n z e i c h n e t, daß die Widerstandsschicht einen positiven Temperaturkoeffizienten aufweist und daß die Glimmpolymerisatschicht ein Mischpolymerisat aus Perfluordimethylcyclohexan und Cyclohexan ist und daß der daraus gefertigte Kondensator einen Temperaturkoeffi-zienten der Kapazität zwischen 0ppm/K und -200ppm/K aufweist.

3. RC-Netzwerk nach Anspruch 2, d a d u r c h g e - k e n n z e i c h n e t, daß die Widerstandsschicht aus Nickelchrom mit einem Temperaturkoeffizienten von +100ppm/K und daß das Dielektrikum aus einem Mischpolymerisat gebildet ist, welches 10% Polymerisatanteile von Cyclohexan enthält.

4. Verfahren zur Herstellung eines RC-Netzwerkes nach einem der Ansprüche 1 bis 3, d a d u r c h g e k e n n -z e i c h n e t, daß die Polymerisation in einem Gasge-misch der entsprechenden Zusammensetzung durchgeführt wird.

5. Verfahren zur Herstellung eines RC-Netzwerkes nach Anspruch 1, d a d u r c h  g e k e n n z e i c h n e t, daß das Dielektrikum durch abwechselndes Aufpolymerisieren von Perfluordimethylcyclohexan und Cyclohexan im Verhältnis der Schichtdicken gemäß der Formel

$$TK_c = \frac{d_1 TK_{c1} + d_2 TK_{c2} + \ldots d_n TK_{cn}}{d_1 + d_2 + \ldots d_n}$$

hergestellt wird.